# EUROPÄISCHE PATENTANMELDUNG

(11) **EP 3 651 361 A1**
(43) Veröffentlichungstag der Anmeldung: **13.05.2020**
(21) Anmeldenummer: 19207518.2
(22) Anmeldetag: 06.11.2019
(51) Int. Cl.: H03K 17/955, H03K 17/96

(54) **SENSORVORRICHTUNG**

(30) Priorität: 06.11.2018 DE 102018127681; 07.12.2018 DE 102018131364
(71) Anmelder: Huf Hülsbeck & Fürst GmbH & Co. KG, 42551 Velbert (DE)
(72) Erfinder: Bextermöller, Hubert, 45468 Mülheim an der Ruhr (DE)
(74) Vertreter: Patentanwälte Bals & Vogel

(57) **Zusammenfassung**

Die Erfindung betrifft eine Sensorvorrichtung (10) zumindest zur kapazitiven Erfassung einer Aktivierungshandlung bei einem Fahrzeug (1), insbesondere für einen Türgriff (2) des Fahrzeuges (1), aufweisend:
- eine Leiterplattenanordnung (20) zur Bereitstellung einer elektrischen Anordnung (70) der Sensorvorrichtung (10), insbesondere für eine Türgriffelektronik,
- ein Sensorelement (40), welches elektrisch leitfähig an der Leiterplattenanordnung (20) ausgebildet ist, um die kapazitive Erfassung der Aktivierungshandlung bereitzustellen,
- eine Abschirmanordnung (60), welche elektrisch leitfähig an der Leiterplattenanordnung (20) in wenigstens zwei Abständen (D1, D2, D3) zum Sensorelement (40) ausgebildet ist, um eine Abschirmung in den Abständen (D1, D2, D3) für das Sensorelement (40) bereitzustellen, wobei die Abstände (D1, D2, D3) mit einem Einfluss auf die kapazitive Erfassung korrelieren,
wobei die Abstände (D1, D2, D3) insbesondere angepasst an die elektrische Anordnung (70) variieren, vorzugsweise maximiert sind, um den Einfluss begrenzt durch die elektrische Anordnung (70) zu reduzieren.

## Beschreibung

Die vorliegende Erfindung betrifft eine Sensorvorrichtung für ein Fahrzeug. Ferner bezieht sich die Erfindung auf einen Türgriff für ein Fahrzeug sowie ein Verfahren zur Herstellung einer Sensorvorrichtung.

Aus dem Stand der Technik ist bekannt, dass kapazitive Sensoren in Türgriffen von Fahrzeugen eingesetzt werden, um eine Berührung und/oder eine Annäherung an den Türgriff zu erfassen. Ebenfalls ist es bekannt, dass Abschirmelemente genutzt werden, um einen Erfassungsbereich am Türgriff für den Sensor zu definieren.

Hierbei ist oft ein Nachteil, dass durch ein solches Abschirmelement auch ein störender Einfluss auf die Erfassung verursacht wird. Eine Verringerung dieses Einflusses kann mit einem enormen technischen Aufwand einhergehen.

Es ist daher eine Aufgabe der vorliegenden Erfindung, die voranstehend beschriebenen Nachteile zumindest teilweise zu reduzieren. Insbesondere ist es eine Aufgabe, eine verbesserte kapazitive Erfassung bei einer Sensorvorrichtung für ein Fahrzeug bereitzustellen.

Die voranstehende Aufgabe wird gelöst durch eine Sensorvorrichtung mit den Merkmalen des unabhängigen Vorrichtungsanspruchs, ein Türgriff mit den Merkmalen des weiteren unabhängigen Vorrichtungsanspruchs sowie durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Sensorvorrichtung beschrieben sind, selbstverständlich auch im Zusammenhang mit dem erfindungsgemäßen Türgriff sowie dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Sensorvorrichtung zumindest oder ausschließlich zur kapazitiven Erfassung einer Aktivierungshandlung bei einem Fahrzeug, insbesondere für einen Türgriff und/oder Stoßfänger und/oder Emblem und/oder dergleichen des Fahrzeuges. Dabei kann die Sensorvorrichtung in einem montierten Zustand in den Türgriff eingebaut und/oder befestigt und/oder durch ein Gehäuse des Türgriffs (vollständig) umgeben sein. Das Gehäuse kann die Sensorvorrichtung z. B. fluiddicht von einer Umgebung des Türgriffs trennen. Auch kann die Sensorvorrichtung in einer Vergussmasse im Türgriff vergossen sein.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist.

Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Die Annäherung kann bspw. durch eine erfindungsgemäße Sensorvorrichtung detektiert werden, insbesondere mittels der kapazitiven Erfassung. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt.

Es ist weiter möglich, dass die Sensorvorrichtung eine elektrische (und vorzugsweise elektronische) Anordnung aufweist, welche zumindest teilweise die Detektion der Aktivierungshandlung bereitstellt und/oder zumindest teilweise eine Türgriffelektronik aufweist. Bspw. kann die Anordnung elektronische Komponenten und ggf. elektrische Bauelemente aufweisen, wie eine Verarbeitungsvorrichtung (z. B. in der Form eines Prozessors oder Mikrocontrollers oder dergleichen) und/oder elektrische Leitungen und/oder wenigstens einen Kondensator und/oder eine Beleuchtung und/oder wenigstens einen optischen Sensor und/oder wenigstens einen kapazitiven Sensor und/oder wenigstens eine für die jeweiligen Sensoren zugehörige Elektrode aufweisen. Ebenfalls kann die Anordnung Leiterbahnen umfassen, welche diese Komponenten bzw. Bauelemente elektrisch miteinander verschaltet. Die Verarbeitungsvorrichtung dient bspw. zur Auswertung der kapazitiven Erfassung.

Eine erfindungsgemäße Sensorvorrichtung kann wenigstens eine der nachfolgenden Komponenten aufweisen, welche optional zumindest teilweise Teil der elektrischen Anordnung sein können:
- eine Leiterplattenanordnung zur Bereitstellung einer (bzw. der) elektrischen Anordnung der Sensorvorrichtung, insbesondere für eine Türgriffelektronik,
- (insbesondere genau) ein Sensorelement, vorzugsweise in der Form einer Sensorelektrode, welches elektrisch leitfähig an der Leiterplattenanordnung ausgebildet sein kann, um die kapazitive Erfassung der Aktivierungshandlung bereitzustellen,
- eine Abschirmanordnung, vorzugsweise in der Form wenigstens oder genau einer Abschirmelektrode, welche elektrisch leitfähig an der Leiterplattenanordnung in wenigstens zwei Abständen zum Sensorelement ausgebildet sein kann, um eine Abschirmung in den Abständen für das Sensorelement bereitzustellen.

Hierbei ist vorzugsweise vorgesehen, dass die Abstände mit einem (insbesondere störenden) Einfluss auf die kapazitive Erfassung korrelieren, vorzugsweise mit einem Störeinfluss wie eine parasitäre Kapazität. Es kann z. B. sein, dass das Ausmaß des Einflusses abhängig und/oder umgekehrt proportional zu den Abständen ist.

Die Abschirmanordnung dient insbesondere dazu, einen Bereich in welchem keine Erfassung der Aktivierungshandlung durch das Sensorelement stattfinden soll (d. h. ein Abschirmbereich), von dem Sensorelement zu trennen (und somit das Sensorelement davon abzuschirmen). Um den störenden Einfluss zu verringern, sollte daher die Abschirmanordnung möglichst weit entfernt (also mit maximalem Abstand) vom Sensorelement angeordnet sein, und entsprechend sich möglichst nahe am gewünschten Abschirmbereich erstrecken.

Die Leiterplattenanordnung kann wenigstens eine Leiterplatte z. B. in der Form einer Lage aufweisen. Auch kann die Leiterplattenanordnung in der Form einer mehrlagigen Leiterplatte ausgebildet sein, und somit mehrere Leiterplatten (auch: Leiterplattenebenen oder Lagen) gestapelt übereinander aufweisen. Diese Lagen können z. B. aufeinander geklebt sein (insbesondere mittels sogenannter Prepregs), wobei die elektrischen Verbindungen zwischen den Lagen über Kontaktierungen, insbesondere Durchkontaktierungen (Vias) hergestellt sein können. Jede dieser Lagen kann ggf. Teile der elektrischen Anordnung aufweisen, welche z. B. an der jeweiligen Lage befestigt und/oder mit einer Leiterbahn der jeweiligen Lage elektrisch verbunden sind. Auf diese Weise kann platzsparend und mit hoher Packungsdichte die elektrische Anordnung durch die Leiterplattenanordnung bereitgestellt werden. Die konkrete Anordnung dieser elektrischen Anordnung an der jeweiligen Lage bestimmt dabei die Topographie bzw. den konkreten Aufbau der Leiterplattenanordnung, und beeinflusst somit die Anordnung der Abschirmanordnung. Insbesondere kann sich dabei ein Einfluss der elektrischen Anordnung als für die kapazitive Erfassung störend herausstellen, wenn Teile der elektrischen Anordnung benachbart zum Sensorelement angeordnet sind. Entsprechend kann es als eine Beschränkung für die Anordnung der Abschirmanordnung vorgesehen sein, dass zumindest ein Teil der elektrischen Anordnung in dem gewünschten Abschirmbereich vorgesehen sind. Auch kann es gegeben sein, dass die Möglichkeiten zur Anordnung der Abschirmanordnung an der Leiterplattenanordnung durch zumindest einen Teil der elektrischen Anordnung (z. B. räumlich) beschränkt werden, sodass der tatsächliche Abschirmbereich nicht vollständig einem gewünschten Abschirmbereich entspricht.

Herkömmlicherweise wird daher ein fester Abstand zwischen dem Sensorelement und der Abschirmanordnung gewählt, welcher durch die Beschränkung der elektrischen Anordnung vorgegeben ist.

Es ist bei einer erfindungsgemäßen Sensorvorrichtung allerdings möglich, dass die Abstände (der Abschirmanordnung zum Sensorelement) - insbesondere angepasst an die elektrische Anordnung - variieren, vorzugsweise (z. B. lokal) maximiert sind, um bevorzugt den Einfluss begrenzt durch die elektrische Anordnung zu reduzieren. Somit ist es ein Erfindungsgedanke, dass unterschiedliche Abstände eine flexible Anpassung an die elektrische Anordnung ermöglichen. Damit kann vermieden werden, dass nur ein einziger fester Abstand der Abschirmanordnung zum Sensorelement vorgesehen ist. So ist es z. B. denkbar, dass eine Beschränkung (z. B. durch die elektrische Anordnung) vorgesehen ist, welche den geringsten der Abstände definiert. In anderen Worten könnte eine Störquelle (wie die elektrische Anordnung) die kapazitive Erfassung des Sensorelements beeinträchtigen, wenn dieser geringste der Abstände größer gewählt werden würde. Ein Nachteil eines herkömmlichen festen Abstandes (d. h. alle Abstände sind identisch) ist es, dass diese einzige Beschränkung, welche den geringsten der Abstände definiert, auch die anderen Abstände verringert und damit den störenden Einfluss (insbesondere eine parasitäre Kapazität) durch die Abstände erhöht. Erfindungsgemäß kann hingegen nur lokal im Bereich dieser Beschränkung (bzw. der Störquelle) der Abstand verringert sein, und außerhalb dieses Bereichs erhöht werden. Auf diese Weise findet eine lokale Maximierung der Abstände statt. Eine mögliche Ausführung dieser lokalen Maximierung ist es z. B., die Abschirmanordnung in einer Stufenform auszubilden. Selbstverständlich umfasst dabei im Rahmen der Erfindung eine "Maximierung" auch Abweichungen von einem rechnerischen Maximum und/oder die Berücksichtigung von Randbedingungen, um die Maximierung im Sinne einer Optimierung bereitzustellen. Daher können aus praktischen und/oder herstellungstechnischen Erwägungen die Abstände zwar an einen maximal möglichen Abstand angepasst sein und sich daran orientieren, jedoch diesem nicht unbedingt vollständig entsprechen.

Es ist ferner denkbar, dass das Sensorelement dazu ausgeführt ist, die kapazitive Erfassung in einem Erfassungsbereich bereitzustellen, um insbesondere die Aktivierungshandlung als eine Annäherung im Erfassungsbereich zu detektieren. Dabei kann die Abschirmanordnung (vorzugsweise in einer Abschirmrichtung) versetzt gemäß den Abständen vom Sensorelement angeordnet sein. In anderen Worten kann die Abschirmanordnung sich ungerade und vorzugsweise stufig gegenüber dem Sensorelement erstrecken, um das Sensorelement von einem Abschirmbereich (insbesondere in der Abschirmrichtung) gegenüberliegend zum Erfassungsbereich abzuschirmen. Insbesondere wird durch die ungerade Erstreckung die Variation der Abstände bewirkt, sodass bei einer geraden Erstreckung und/oder Erstreckung der Abschirmanordnung parallel zum Sensorelement der Abstand nicht variieren d. h. fest sein würde. Damit kann flexible der Abstand der Abschirmanordnung zum Sensorelement variiert werden, und die Verringerung des Einflusses, insbesondere einer parasitären Kapazität, optimiert werden.

Auch ist es optional denkbar, dass die Leiterplattenanordnung als eine mehrlagige (auch engl. Multilayer-) Leiterplatte ausgebildet ist, sodass (insbesondere in Abschirmrichtung) verschiedene Lagen (auch: Ebenen oder Layer) der Leiterplattenanordnung vorgesehen sind, wobei vorzugsweise die Abschirmanordnung wenigstens zwei Abschirmelemente aufweist, welche an unterschiedlichen der Lagen angeordnet sind. Durch diese unterschiedliche Anordnung können die Abstände (vorzugsweise in Abschirmrichtung) variiert werden, um die kapazitive Erfassung zu optimieren.

Bspw. sind die Abstände als die Abstände unterschiedlicher der Abschirmelemente definiert. Ein erstes der Abschirmelemente hat somit einen ersten der Abstände zum Sensorelement, ein zweites der Abschirmelemente einen zweiten der Abstände zum Sensorelement, ggf. usw., sodass die Abschirmelemente in unterschiedlicher Distanz zum Sensorelement angeordnet sind.

Vorteilhafterweise kann bei der Erfindung vorgesehen sein, dass das Sensorelement und die Abschirmanordnung, insbesondere mit sämtlichen der Abschirmelemente der Abschirmanordnung, zumindest teilweise in einer gemeinsamen Ebene angeordnet sind, welche vorzugsweise orthogonal zur Leiterplattenebene einer (der) Lage(n) der Leiterplattenanordnung ist, wobei bevorzugt eine Abschirmrichtung orthogonal zur Leiterplattenebene und/oder parallel zur gemeinsamen Ebene verläuft, und besonders bevorzugt eine Hochrichtung orthogonal zur gemeinsamen Ebene und parallel zur Leiterplattenebene verläuft, wobei optional die Abstände in Richtung der Abschirmrichtung variieren. Die Hochrichtung kann im montierten Zustand am Fahrzeug zumindest annähernd einer Fahrzeughochachse entsprechen, wobei je nach Montageposition auch Abweichungen dazu möglich sind. Die Anordnung in der gemeinsamen Ebene definiert, dass die Abschirmanordnung zur Bereitstellung der Abschirmung für das Sensorelement dient, und es somit dem Sensorelement funktional primär und fest zugewiesen ist. Die Orthogonalität der gemeinsamen Ebene zur Leiterplattenebene hat den Vorteil, dass die Variation der Abstände und damit z. B. die Abstufung der Abschirmanordnung in Stapelrichtung der Lagen der Leiterplattenanordnung erfolgen kann. Damit kann die Variation in einfacher Weise mittels Kontaktierungen, insbesondere Durchkontaktierungen der Leiterplattenanordnung ermöglicht werden. Auch kann somit eine Beeinträchtigung durch die elektrische Anordnung (z. B. eine Störquelle) durch die Abschirmanordnung in Stapelrichtung umgangen werden.

Ferner ist es denkbar, dass der jeweilige Abstand als ein kürzester Abstand eines jeweiligen Abschirmelements der Abschirmanordnung vom Sensorelement definiert ist, und insbesondere über die Variation (der Abstände) begrenzt durch die elektrische Anordnung maximiert ist (bzw. wird), um den Einfluss (z. B. die parasitäre Kapazität) maximal zu reduzieren. Es kann sich ebenfalls bei dem jeweiligen Abstand um den generell kürzesten Abstand der Abschirmanordnung an der Position (z. B. in Hochrichtung) des jeweiligen Abschirmelements handeln. In anderen Worten kann zwischen dem Abschirmelement mit dem kürzesten Abstand und dem Sensorelement nicht noch ein weiteres Abschirmelement vorgesehen sein. Dies hat den Vorteil, dass die Erhöhung des Abstands den Einfluss tatsächlich auch reduzieren kann, da die Maximierung an der Stelle der kürzesten Entfernung erfolgt.

Ferner ist es optional vorgesehen, dass eine Differenz von zwei der variierten Abstände einem (ganzzahligen) ein- oder vielfachen Abstand zwischen zwei Lagen der Leiterplattenanordnung entspricht, und insbesondere die variierten Abstände stets durch ein (ganzzahliges) Ein- oder Vielfaches der Lagenabstände voneinander abweichen. In anderen Worten können die Abschirmelemente der Abschirmanordnung auf verschiedenen Lagen angeordnet sein, um die Abstände zu variieren.

Des Weiteren ist es denkbar, dass der Einfluss auf die kapazitive Erfassung eine parasitäre Kapazität ist, welche insbesondere durch das Sensorelement und die Abschirmanordnung derart bereitgestellt ist, dass eine Verringerung des Abstands zwischen dem Sensorelement und der Abschirmanordnung die parasitäre Kapazität erhöht, und/oder wobei dadurch die Abstände mit dem Einfluss korrelieren, dass die Verringerung des Abstands zwischen dem Sensorelement und der Abschirmanordnung die parasitäre Kapazität erhöht. Entsprechend kann der Einfluss für eine Beeinträchtigung bei der kapazitiven Erfassung spezifisch sein. Diese Beeinträchtigung ist vorteilhafterweise geringer als eine Beeinträchtigung durch eine Störquelle der elektrischen Anordnung, von welcher das Sensorelement durch die Abschirmanordnung abgeschirmt wird. So würde z. B. eine fehlende Abschirmung von einem weiteren Sensorelement als Störquelle stets zu einer besonders stark eingeschränkten oder fehlerhaften kapazitiven Erfassung beider Sensorelemente führen. Dieser Nachteil kann durch eine erfindungsgemäße Sensorvorrichtung zumindest reduziert werden.

Ein weiterer Vorteil kann im Rahmen der Erfindung erzielt werden, wenn die Abschirmanordnung abgestuft an der Leiterplattenanordnung angeordnet ist, vorzugsweise über mehrere Lagen der Leiterplattenanordnung, sodass vorteilhafterweise die Stufen in den variierten Abständen zum Sensorelement angeordnet sind. In anderen Worten können die Stufen durch die Variation der Abstände bewirkt werden, z. B. durch Kontaktierungen, insbesondere Durchkontaktierungen der Leiterplattenanordnung. Damit wird eine einfache geometrische Maßnahme bereitgestellt, um den negativen Einfluss der geringeren Abstände auf die Erfassung zu reduzieren.

Des Weiteren ist es denkbar, dass die Leiterplattenanordnung als eine mehrlagige Leiterplatte wenigstens zwei Lagen oder genau vier Lagen aufweist. Auch kann die Abschirmanordnung wenigstens zwei Abschirmelemente aufweisen, welche auf unterschiedlichen der Lagen der Leiterplattenanordnung befestigt sind. So ist es möglich, dass das jeweilige Abschirmelement und/oder ebenfalls das Sensorelement als Leiterbahn oder dergleichen ausgeführt ist. Vorteilhafterweise sind die Abschirmelemente durch wenigstens eine Kontaktierung, insbesondere Durchkontaktierung, miteinander elektrisch verbunden, wobei ein erstes der Abschirmelemente einen ersten der Abstände zum Sensorelement aufweist, und ein zweites der Abschirmelemente einen zweiten der Abstände zum Sensorelement aufweist, welche vorzugsweise jeweils die weitesten Abstände zwischen der Leiterplattenanordnung und dem Sensorelement sind. Die Verbindung mittels der Kontaktierung, insbesondere Durchkontaktierung, stellt eine einfache und zuverlässige Möglichkeit dar, die Abschirmelemente auf den unterschiedlichen Lagen auf ein gemeinsames elektrisches Potential zu legen. Damit können sämtliche Abschirmelemente der Abschirmanordnung eine einzige Abschirmelektrode ausbilden.

In einer weiteren Möglichkeit kann vorgesehen sein, dass die Sensorvorrichtung die elektrische Anordnung aufweist, insbesondere als eine Elektronikanordnung an wenigstens einer Lage der Leiterplattenanordnung. Dabei kann die elektrische Anordnung wenigstens eine Leitung (z. B. der Sensorvorrichtung oder nicht zur Sensorvorrichtung gehörend) und/oder wenigstens eine Verarbeitungsvorrichtung und/oder wenigstens ein weiteres Sensorelement aufweisen, die vorzugsweise jeweils über die Abschirmanordnung vom Sensorelement getrennt und/oder abgeschirmt sind und/oder die Abstände beeinflussen. Bspw. können elektrische Ströme oder Potentiale bei der elektrischen Anordnung, welche im Betrieb der Sensorvorrichtung auftreten, die kapazitive Erfassung stören. Daher kann die Abschirmanordnung zur Abschirmung zumindest zur Reduzierung dieser Störung eingesetzt werden.

Es ist möglich, dass das Sensorelement als ein erstes Sensorelement einen kapazitiven Annäherungssensor bereitstellt, und vorzugsweise das weitere Sensorelement einen kapazitiven Berührungssensor bereitstellt. "Kapazitiv" bezieht sich insbesondere darauf, dass eine Veränderung einer Kapazität (bereitgestellt durch das jeweilige Sensorelement) gemessen wird, um die Aktivierungshandlung (das Annähern bzw. Berühren) zu erfassen. Die Kapazität bildet sich bspw. in Abhängigkeit von einer Umgebung des jeweiligen Sensorelements gegenüber Masse aus.

Außerdem ist es von Vorteil, wenn die Abschirmanordnung wenigstens ein Abschirmelement aufweist, welches dazu ausgeführt und vorzugsweise dazu angeordnet ist, sowohl für das Sensorelement, als auch für ein weiteres Sensorelement an der Leiterplattenanordnung eine Abschirmung bereitzustellen. In anderen Worten kann eine einzige Abschirmanordnung, insbesondere als eine einzige Abschirmelektrode, für wenigstens zwei Sensorelemente eine Abschirmung bereitstellen. Damit kann der Platzaufwand deutlich reduziert werden. Ein verringerter Platzaufwand hat zudem zur Folge, dass die Abstände der Abschirmanordnung weiter vergrößert werden können. In Bezug auf das weitere Sensorelement kann zur Maximierung dieser Abstände allerdings eine Randbedingung sein, dass auch weitere Abstände der Abschirmanordnung zum weiteren Sensorelement maximiert werden oder einen Mindestabstand nicht unterschreiten.

Es kann weiter möglich sein, dass wenigstens ein Abschirmelement der Abschirmanordnung zwischen dem Sensorelement und wenigstens einem weiteren Sensorelement angeordnet ist, vorzugsweise in einer Lage zwischen den Lagen dieser Sensorelemente, um die Abschirmung als gegenseitige Abschirmung für mehrere Sensorelemente bereitzustellen. Es kann sich somit bei der Abschirmung um eine elektrische Entkopplung der Sensorelemente handeln. Dies ermöglicht es, für die Sensorelemente unterschiedliche Erfassungsbereiche für die kapazitive Erfassung bereitzustellen, welche z. B. auf gegenüberliegenden Seiten der Sensorvorrichtung angeordnet sind.

Ferner kann im Rahmen der Erfindung vorgesehen sein, dass neben dem Sensorelement als ein erstes Sensorelement wenigstens ein weiteres Sensorelement zur kapazitiven Erfassung an der Leiterplattenanordnung angeordnet ist, wobei sich vorzugsweise ein erster Erfassungsbereich des ersten Sensorelements von wenigstens einem weiteren Erfassungsbereich des wenigstens einen weiteren Sensorelements unterscheidet. Bevorzugt kann die Abschirmanordnung zumindest teilweise benachbart zum wenigstens einen weiteren Sensorelement angeordnet sein, um durch die Abschirmanordnung und vorzugsweise wenigstens ein Abschirmelement der Abschirmanordnung sowohl für das erste Sensorelement, als auch für das weitere Sensorelement die Abschirmung von unterschiedlichen Abschirmbereichen bereitzustellen. Bspw. ist das weitere Sensorelement im Abschirmbereich für das erste Sensorelement angeordnet und das erste Sensorelement im Abschirmbereich für das weitere Sensorelement angeordnet, sodass sich die Sensorelemente gegenseitig nicht wesentlich beeinflussen können. Die Abschirmbereiche können sich zudem auch über weitere Bereiche der Leiterplattenanordnung erstrecken.

Ein weiterer Vorteil im Rahmen der Erfindung ist erzielbar, wenn für das Sensorelement und wenigstens ein weiteres Sensorelement nur eine Abschirmanordnung vorgesehen ist, welche vorteilhafterweise ausschließlich elektrisch miteinander verbundene potentialgleiche Abschirmelemente aufweist, wobei sich die Abschirmelemente versetzt und/oder stufig über mehrere Lagen der Leiterplattenanordnung zwischen den Sensorelementen erstrecken. Die Potentialangleichung kann z. B. durch eine elektrische Verbindung der Abschirmelemente miteinander erfolgen. Die Verbindung erfolgt insbesondere lagenübergreifend, z. B. mittels Kontaktierungen, insbesondere Durchkontaktierungen. Auf diese Weise kann eine einheitliche Abschirmung durch die Abschirmanordnung als (eine einzige) Abschirmelektrode erfolgen.

Wenn die Abschirmanordnung als eine einzige Abschirmelektrode ausgebildet ist, kann die Variation der Abstände den Einfluss insbesondere in der Form einer (einzigen) parasitären Kapazität bestimmen. Diese (einzige) parasitäre Kapazität wird durch die Abschirmelektrode hervorgerufen, welche benachbart zum Sensorelement angeordnet ist. Sie kann sich bspw. als ein Signaloffset bei der Signalerfassung bei dem Sensorelement auswirken, wenn die Aktivierungshandlung durch die Signalerfassung und eine Signalverarbeitung detektiert wird. Die Signalerfassung und -verarbeitung kann bspw. durch eine Verarbeitungsvorrichtung erfolgen. Jede Verringerung eines der Abstände kann dabei ggf. eine Verringerung dieser parasitären Kapazität bewirken.

Vorteilhafterweise kann im Rahmen der Erfindung vorgesehen sein, dass sämtliche Abschirmelemente der Abschirmanordnung auf einem gleichen (elektrischen) Potential liegen und elektrisch miteinander, insbesondere lagenübergreifend, verbunden sind. Dies ermöglicht eine einfache und zuverlässige Abschirmung, wobei ggf. hierzu nur eine der Abschirmelemente mit einer Verarbeitungsvorrichtung verbunden sein muss.

Es kann vorteilhafterweise eine Verarbeitungsvorrichtung vorgesehen sein, um anhand der kapazitiven Erfassung die Aktivierungshandlung zu detektieren. Hierzu kann die Verarbeitungsvorrichtung z. B. eine Ladungsübertragung von dem Sensorelement initiieren und die übertragene Ladung quantitativ auswerten. Anhand dieser Auswertung kann z. B. ein Vorliegen der Aktivierungshandlung indiziert werden.

Von weiterem Vorteil kann vorgesehen sein, dass die Abschirmanordnung dazu ausgeführt ist, die Abschirmung als eine aktive Abschirmung bereitzustellen, um ein elektrisches Potential der Abschirmanordnung dynamisch an die Erfassung durch das Sensorelement anzupassen. In anderen Worten kann das elektrische Potential, welches an der Abschirmanordnung (und ggf. jedem Abschirmelement der Abschirmanordnung) anliegt, während eines Betriebs der Sensorvorrichtung verändert werden.

Es kann ferner vorgesehen sein, dass wenigstens ein Abschirmelement der Abschirmanordnung, wie eine Schildelektrode, vorgesehen ist. Eine elektrische Verbindung der Abschirmelemente miteinander kann dabei bewirken, dass die Abschirmanordnung als Ganzes als Schildelektrode angesehen werden kann. Das Abschirmelement kann in der Umgebung des Sensorelements angeordnet sein, um die Erfassung durch das Sensorelement zu verbessern und/oder zu richten. Hierzu kann das Abschirmelement auf ein festes elektrisches Potential gelegt werden, wie bspw. ein Massepotential oder ein davon abweichendes festes Potential, z. B. einer Betriebsspannungsquelle. In diesem Fall wird von einer passiven Abschirmung gesprochen. Vorzugsweise wird das Abschirmelement (bspw. zur Aufladung des Sensorelements und/oder zur Ladungsübertragung) aktiv auf das gleiche Potential gelegt wie das Sensorelement. Durch diese aktive Abschirmung wird der Vorteil erzielt, dass kein störender Stromfluss aufgrund einer zwischen dem Abschirmelement und dem Sensorelement ausgebildeten parasitären Kapazität entsteht, was zu einer verbesserten Erfassung führen kann. Bei einer Ladungsübertragung kann ggf. das Potential des Abschirmelements verändert werden, um die Ladung des Sensorelements z. B. an eine Halteanordnung zu übertragen. Hierzu wird bspw. das Potential des Abschirmelements auf das Massepotential gelegt. Das Abschirmelement ist vorteilhafterweise geometrisch so ausgeführt, dass ein gewünschtes Überwachungsfeld als Erfassungsbereich zur Erfassung in der Umgebung des Sensorelements entsteht. Bspw. kann das Abschirmelement das Überwachungsfeld begrenzen, sodass nur in einem vom Abschirmelement begrenzten und/oder nicht vom Abschirmelement abgeschirmten Bereich die Erfassung der Aktivierungshandlung erfolgt. Auf diese Weise kann mittels des Abschirmelements bewirkt werden, dass z. B. die Aktivierungshandlung nur aus einer bestimmten Richtung (entgegengesetzt einer Abschirmrichtung) des Sensorelements erfasst wird. Das Abschirmelement wird z. B. durch die Ansteuerungs- und/oder Verarbeitungsvorrichtung aktiv auf das gewünschte Potential gelegt.

Es ist bei einer erfindungsgemäßen Sensorvorrichtung denkbar, dass immer dann, wenn das Potential am Sensorelement verändert wird, auch aktiv das Potential am Abschirmelement (z. B. auf das gleiche Potential) verändert wird. Auch kann ggf. das Potential am Abschirmelement dann verändert werden (z. B. von einem festen vom Massepotential abweichenden Potential auf ein Massepotential), wenn die Ladungsübertragung erfolgt.

Auch ist es optional denkbar, dass das Sensorelement als ein erstes Sensorelement angrenzend zu einer Rückseite der Sensorvorrichtung angeordnet ist, um in einem (in einen Türgriff) montierten Zustand eine Türgriffmulde an der Rückseite zu überwachen, wobei vorzugsweise ein weiteres Sensorelement, insbesondere in Abschirmrichtung gegenüberliegend, angrenzend zu einer Vorderseite der Sensorvorrichtung angeordnet ist, um in dem montierten Zustand einen vorderen Bereich des Türgriffs an der Vorderseite zu überwachen. Damit können zuverlässig verschiedene Aktivierungshandlungen durch eine Sensorvorrichtung ggf. mit einer einzigen Leiterplattenanordnung überwacht werden.

Beispielsweise kann es vorgesehen sein, dass das Sensorelement als ein erstes Sensorelement dazu ausgeführt ist, bei Erfassung der Aktivierungshandlung als eine erste Aktivierungshandlung, insbesondere eine Annäherung und/oder ein Eingreifen in eine Türgriffmulde, eine erste Funktion des Fahrzeugs zu initiieren, vorzugsweise ein Entriegeln und/oder Öffnen des Fahrzeuges, und bevorzugt ein weiteres Sensorelement dazu ausgeführt ist, bei Erfassung einer zweiten Aktivierungshandlung, insbesondere eine Berührung des Türgriffs an einer Vorderseite, eine zweite Funktion des Fahrzeugs zu initiieren, vorzugsweise ein Verriegeln und/oder Schließen des Fahrzeuges. Damit ist eine einfache und komfortable Bedienung des Fahrzeuges bereitgestellt, vorzugsweise ohne einen ID-Geber aktiv für die Funktion zu betätigen. Dabei kann die jeweilige Funktion als eine sicherheitsrelevante Funktion ausgebildet sein, sodass ggf. eine positive Authentifizierung als Bedingung für die Aktivierung vorausgesetzt wird.

Ferner ist es optional vorgesehen, dass eine Anpassung wie eine Leiterplattenanpassung der Leiterplattenanordnung und/oder eine Abschirmelementanpassung vorgesehen ist, um die Abschirmung zu unterstützten, wobei die Anpassung vorzugsweise als eine Mehrzahl von Ausnehmungen, insbesondere Bohrungen, in der Leiterplattenanordnung und/oder in wenigstens einem der Abschirmelemente der Abschirmanordnung ausgeführt ist. Dabei kann die Leiterplattenanpassung an einem Rand und/oder an einer Kante der Leiterplattenanordnung ausgebildet sein. Die Anpassung kann vorzugsweise ein elektrisches Feld beeinflussen, welches durch die Abschirmung hervorgerufen wird. Insbesondere kann auf diese Weise die elektrische Spitzenwirkung (Spitzeneffekt) für das elektrische Feld verbessert und insbesondere verstärkt werden. Damit kann die Abschirmung verbessert werden. Alternativ oder zusätzlich kann das Abschirmelement im Bereich des Randes und/oder der Kante und/oder die Leiterplattenanordnung im Bereich des Randes und/oder der Kante beschichtet und/oder verkupfert werden, um einen ähnlichen Effekt zu erzielen.

Des Weiteren ist es denkbar, dass eine Leiterplattenanpassung der Leiterplattenanordnung und/oder eine Anpassung der Abschirmanordnung lagenübergreifend an einem Seitenbereich und/oder Kantenbereich der Leiterplattenanordnung vorgesehen ist, um vorzugsweise in einem montierten Zustand einem Störelement, insbesondere einer Chromblende, des Türgriffs zugewandt angeordnet zu sein, und um damit einen Einfluss des Störelements auf die Erfassung zu reduzieren. Dies kann insbesondere dadurch ermöglicht werden, dass eine Wirkung und/oder Feldstärke der Abschirmung in diesem Bereich erhöht wird. Auf diese Weise kann auch auf eine Verbindung mit einem elektrischen Massepotential für das Störelement verzichtet werden, sodass bspw. die Chromblende kein Massepotential aufweist.

In einer weiteren Möglichkeit kann vorgesehen sein, dass eine Leiterplattenanpassung der Leiterplattenanordnung und/oder eine Anpassung der Abschirmanordnung mehrere Ausnehmungen der Leiterplatte der Leiterplattenanordnung und/oder wenigstens eines Abschirmelements der Abschirmanordnung aufweist, welche vorteilhafterweise versetzt und insbesondere äquidistant in Längsrichtung parallel zur Leiterplattenebene und orthogonal zur Abschirmrichtung und/oder in Abschirmrichtung lagenübergreifend angeordnet sind. Somit wird eine besonders vorteilhafte Abschirmung erzielt.

Ebenfalls Gegenstand der Erfindung ist ein Türgriff für ein Fahrzeug, in welchem eine erfindungsgemäße Sensorvorrichtung montiert ist. Damit bringt der erfindungsgemäße Türgriff die gleichen Vorteile mit sich, wie sie ausführlich mit Bezug auf eine erfindungsgemäße Sensorvorrichtung beschrieben worden sind.

Ebenfalls Gegenstand der Erfindung ist ein Verfahren zur Herstellung einer Sensorvorrichtung, insbesondere einer erfindungsgemäßen Sensorvorrichtung.

Hierbei ist vorgesehen, dass die nachfolgenden Schritte durchgeführt werden, vorzugsweise nacheinander in der angegebenen oder in beliebiger Reihenfolge:
- Bereitstellen einer Leiterplattenanordnung, welche dazu ausgeführt ist, eine elektrische Anordnung für die Sensorvorrichtung zu tragen, wobei vorzugsweise mehrere einzelne Lagen der Leiterplattenanordnung bereitgestellt werden,
- Ausbilden eines Sensorelements elektrisch leitfähig an der Leiterplattenanordnung, vorzugsweise durch ein Befestigen einer elektrisch leitfähigen (insbesondere Metall-) Fläche an der Leiterplattenanpassung, bevorzugt auf einer der Lagen,
- Ausbilden einer Abschirmanordnung elektrisch leitfähig an der Leiterplattenanordnung in wenigstens zwei Abständen zum Sensorelement, vorzugsweise durch ein Befestigen einer abgestuften elektrisch leitfähigen (insbesondere Metall-) Fläche an der Leiterplattenanpassung, bevorzugt an mehreren der Lagen, wobei insbesondere die Abstände mit einem Einfluss auf die kapazitive Erfassung korrelieren.

Dabei kann es vorgesehen sein, dass die Abstände (insbesondere in Abhängigkeit von der elektrischen Anordnung) variiert werden, vorzugsweise maximiert werden, um den Einfluss begrenzt durch die elektrische Anordnung zu reduzieren. Damit bringt das erfindungsgemäße Verfahren die gleichen Vorteile mit sich, wie sie ausführlich mit Bezug auf eine erfindungsgemäße Sensorvorrichtung beschrieben worden sind.

Es kann möglich sein, dass als ein weiterer Verfahrensschritt die Lagen miteinander befestigt werden, um eine erfindungsgemäße Sensorvorrichtung bereitzustellen. Auch ist es denkbar, dass die elektrische Anordnung und/oder ein weiteres Sensorelement zuvor an wenigstens eine der Lagen befestigt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: ein schematisches Schaltbild von Teilen einer erfindungsgemäßen Sensorvorrichtung zur Visualisierung eines Einflusses auf die kapazitive Erfassung,
- Figur 2: eine schematische Schnittansicht von Teilen einer erfindungsgemäßen Sensorvorrichtung,
- Figur 3: eine weitere schematische Schnittansicht von Teilen einer erfindungsgemäßen Sensorvorrichtung,
- Figur 4: eine weitere schematische Schnittansicht von Teilen einer erfindungsgemäßen Sensorvorrichtung,
- Figur 5: weitere schematische Ansichten von Teilen einer erfindungsgemäßen Sensorvorrichtung.

In den nachfolgenden Figuren werden für die gleichen technischen Merkmale auch von unterschiedlichen Ausführungsbeispielen die identischen Bezugszeichen verwendet.

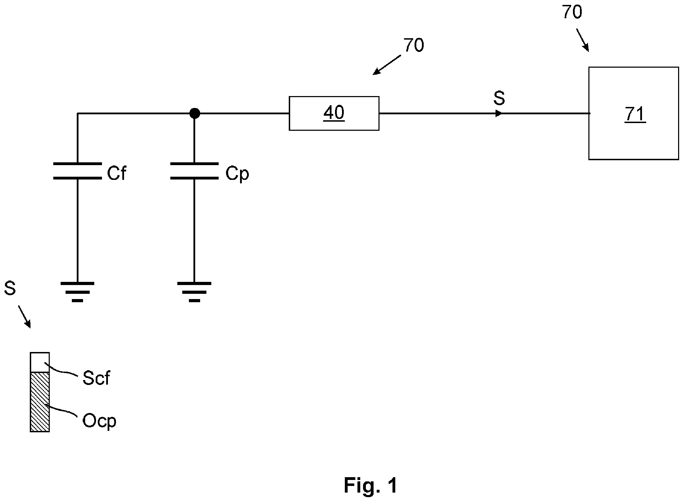

Wie anhand der Figuren 1 bis 5 erkennbar ist, kann eine erfindungsgemäße Sensorvorrichtung 10 zumindest zur kapazitiven Erfassung einer Aktivierungshandlung bei einem Fahrzeug 1, insbesondere für einen Türgriff 2 des Fahrzeuges 1, die nachfolgenden Komponenten aufweisen:
- eine Leiterplattenanordnung 20 zur Bereitstellung einer elektrischen Anordnung 70 der Sensorvorrichtung 10, insbesondere für eine Türgriffelektronik,
- ein Sensorelement 40, welches elektrisch leitfähig an der Leiterplattenanordnung 20 ausgebildet ist, um die kapazitive Erfassung der Aktivierungshandlung bereitzustellen,
- eine Abschirmanordnung 60, welche elektrisch leitfähig an der Leiterplattenanordnung 20 in wenigstens zwei Abständen D1, D2, D3 zum Sensorelement 40 ausgebildet ist, um eine Abschirmung in den Abständen D1, D2, D3 für das Sensorelement 40 bereitzustellen, wobei die Abstände D1, D2, D3 mit einem Einfluss auf die kapazitive Erfassung korrelieren, d. h. insbesondere diesen Einfluss quantitativ beeinflussen,
wobei die Abstände D1, D2, D3 insbesondere angepasst an die elektrische Anordnung 70 variieren, vorzugsweise maximiert sind, um den Einfluss begrenzt durch die elektrische Anordnung 70 zu reduzieren.

In Figur 1 ist schematisch ein Schaltbild von Teilen einer erfindungsgemäßen Sensorvorrichtung 10 dargestellt. Dabei ist zunächst grundsätzlich das Erfassungsprinzip visualisiert, bei welchem eine Ladungsübertragung von dem Sensorelement 40 an eine Verarbeitungsvorrichtung 71 durchgeführt wird, um die übertragene Ladung als Erfassungssignal S auszuwerten. Dies ermöglicht es, eine durch das Sensorelement 40 bereitgestellte veränderliche Sensorkapazität Cf auszuwerten. Die Kapazität Cf verändert sich z. B., wenn als Aktivierungshandlung eine Annäherung durch eine Hand eines Bedieners des Fahrzeuges 1 an das Sensorelement 40 erfolgt. Damit ermöglicht das Sensorelement 40 die kapazitive Erfassung. Diese Veränderung kann durch ein Sensorsignal Scf im Gesamtsignal S indiziert werden. Eine in Figur 1 gezeigte Amplitude des Sensorsignals Scf ist z. B. proportional zur Sensorkapazität Cf. Störend wirkt sich jedoch auch eine parasitäre Kapazität Cp als der zuvor beschriebene Einfluss auf die kapazitive Erfassung aus, welche durch die Nähe des Sensorelement 40 zur Abschirmanordnung 60 hervorgerufen wird. Diese wirkt sich als ein Offsetsignal Ocp im Gesamtsignal S aus.

Um das Offsetsignal Ocp zu verringern, können die Abstände D1, D2, D3 erhöht werden. Dies ist jedoch aufgrund von Randbedingungen, wie z. B. der elektrischen Anordnung 70 und/oder eines weiteren Sensorelement 50, nur begrenzt möglich. Daher kann eine erfindungsgemäße Variation der Abstände D1, D2, D3 einen Kompromiss darstellen, um eine optimale Reduzierung des Einflusses zu erreichen, und gleichzeitig die Randbedingungen zu berücksichtigen.

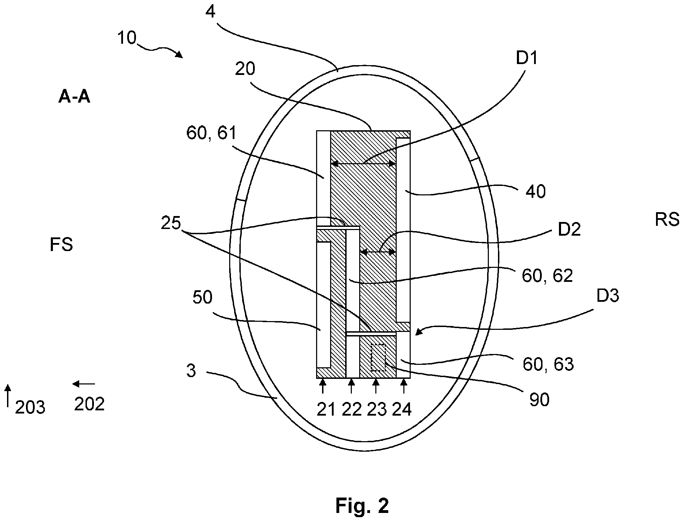

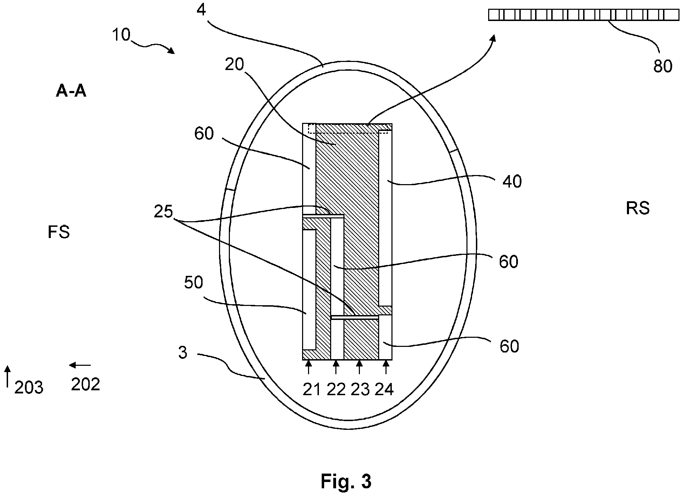

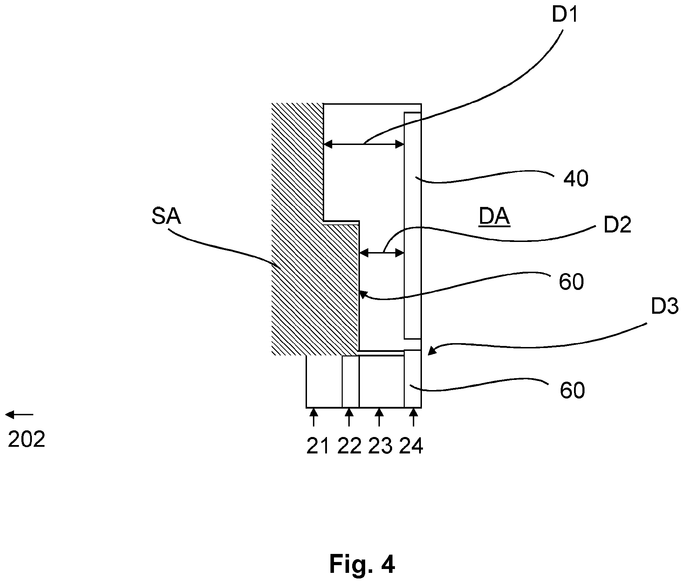

In den Figuren 2 bis 4 sind beispielhafte Ausführungen gezeigt, bei welchen eine derartige Variation der Abstände D1, D2, D3 vorliegt. Wie in Figur 4 dargestellt ist, kann das Sensorelement 40 dazu ausgeführt sein, die kapazitive Erfassung in einem Erfassungsbereich DA bereitzustellen, um die Aktivierungshandlung als eine Annäherung im Erfassungsbereich DA zu detektieren. Gemäß Figur 4 und insbesondere auch Figur 2 und 3 kann dabei die Abschirmanordnung 60 in einer Abschirmrichtung 202 versetzt mit den Abständen D1, D2 (und ggf. D3) vom Sensorelement 40 angeordnet sein, und sich somit ungerade und vorzugsweise stufig gegenüber dem Sensorelement 40 erstrecken, um das Sensorelement 40 von einem Abschirmbereich SA in der Abschirmrichtung 202 gegenüberliegend zum Erfassungsbereich DA abzuschirmen. Die Abschirmanordnung 60 setzt sich dabei aus verschiedenen Abschirmelementen 61, 62, 63 und ggf. den zugehörigen Kontaktierungen 25, insbesondere Durchkontaktierungen 25 zusammen, welche ein gemeinsames gleiches elektrischen Potential aufweisen können.

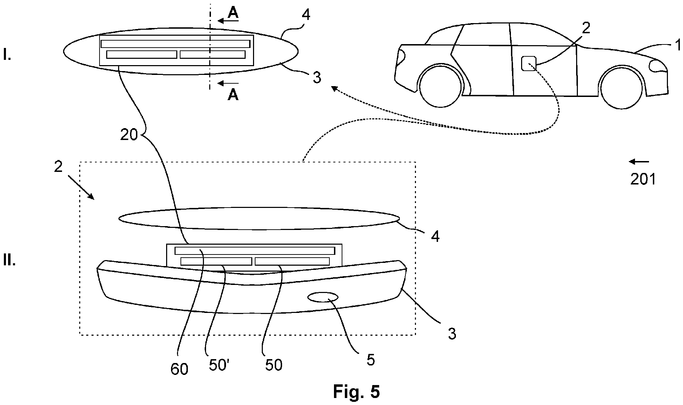

Wie in Figur 2 gezeigt ist, kann die Leiterplattenanordnung 20 als eine mehrlagige Leiterplatte ausgebildet sein, sodass in Abschirmrichtung 202 verschiedene Lagen 21, 22, 23, 24 der Leiterplattenanordnung 20 vorgesehen sind, wobei die Abschirmanordnung 60 wenigstens zwei Abschirmelemente 61, 62, 63 aufweist, welche an unterschiedlichen der Lagen 21, 22, 23, 24 angeordnet sind, um hierdurch die Abstände D1, D2, D3 in Abschirmrichtung zu variieren. Dabei kann das Sensorelement 40 und die Abschirmanordnung 60, insbesondere mit sämtlichen der Abschirmelemente 61, 62, 63 der Abschirmanordnung 60, zumindest teilweise in einer gemeinsamen Ebene angeordnet sein, welche orthogonal zur Leiterplattenebene einer Lage 21, 22, 23, 24 der Leiterplattenanordnung 20 ist, wobei eine Abschirmrichtung 202 orthogonal zur Leiterplattenebene verläuft, und die Abstände D1, D2, D3 in Richtung der Abschirmrichtung 202 variieren. In Figur 2 ist diese gemeinsame Ebene dargestellt, in welcher entsprechend sämtliche der Abschirmelemente 61, 62, 63 und das Sensorelement 40 sichtbar sind. Die in Figur 5 gezeigte Darstellung kann hingegen parallel zur Leiterplattenebene sein. Entsprechend ist der in Figur 2 gezeigte schematische Schnitt A-A durch die Sensorvorrichtung 10 auch in Figur 5 visualisiert.

In Figur 2 ist erkennbar, dass der jeweilige Abstand D1, D2, D3 (z. B. definiert als der kürzeste Abstand eines jeweiligen Abschirmelements 61, 62, 63 der Abschirmanordnung 60 vom Sensorelement 40) über die Variation begrenzt durch die elektrische Anordnung 70 (insbesondere durch das weitere Sensorelement 50) maximiert ist, um den Einfluss maximal zu reduzieren. Dabei kann eine Differenz von zwei der variierten Abstände D1, D2, D3 einem ein- oder vielfachen Abstand zwischen zwei Lagen der Leiterplattenanordnung 20 entsprechen, und somit die variierten Abstände stets durch ein Ein- und/oder Vielfaches der Lagenabstände voneinander abweichen.

Außerdem sind in Figur 2 schematisch Leitungen 90 dargestellt, welche nicht zum Sensorelement 40 oder 50 gehören und grundsätzlich einen störenden Einfluss haben können. Die Leitungen 90 können dabei als Teil der elektrischen Anordnung 70 eine Randbedingung für die Variation darstellen. Diese werden jedoch durch die Abschirmanordnung 60 neutralisiert, und haben daher keinen signifikanten störenden Einfluss auf die kapazitive Erfassung.

Gemäß Figur 2 bis 4 kann die Abschirmanordnung 60 abgestuft an der Leiterplattenanordnung 20 angeordnet sein, nämlich über mehrere Lagen der Leiterplattenanordnung 20, sodass die Stufen 61, 62, 63 in den variierten Abständen D1, D2, D3 zum Sensorelement 40 angeordnet sind.

Außerdem kann die Leiterplattenanordnung 20 als eine mehrlagige Leiterplatte wenigstens zwei Lagen oder genau vier Lagen aufweisen, und die Abschirmanordnung 60 wenigstens zwei Abschirmelemente aufweisen, welche auf unterschiedlichen Lagen 21, 22, 23, 24 der Leiterplattenanordnung 20 befestigt sind, und durch wenigstens eine Kontaktierung 25, insbesondere Durchkontaktierung 25 miteinander elektrisch verbunden sind, wobei ein erstes 61 der Abschirmelemente einen ersten D1 der Abstände zum Sensorelement 40 aufweist, und ein zweites 62 der Abschirmelemente einen zweiten D2 der Abstände zum Sensorelement 40 aufweist.

Das dargestellte Abschirmelement 62 kann zudem dazu ausgeführt und insbesondere angeordnet sein, sowohl für das Sensorelement 40 als auch für ein weiteres Sensorelement 50 an der Leiterplattenanordnung 20 eine Abschirmung bereitzustellen. Hierzu ist gemäß Figur 2 das Abschirmelement 62 der Abschirmanordnung 60 (in Abschirmrichtung 202) zwischen dem Sensorelement 40 und dem wenigstens einen weiteren Sensorelement 50 angeordnet, nämlich in einer Lage 22 zwischen den Lagen 21, 24 dieser Sensorelemente 40, 50, um die Abschirmung als gegenseitige Abschirmung für mehrere Sensorelemente 40, 50 bereitzustellen. Hierdurch kann die Erfassung für beide Sensorelemente 40, 50 verbessert werden. Ein erster Erfassungsbereich DA des ersten Sensorelements 40 kann dabei von wenigstens einem weiteren Erfassungsbereich des wenigstens einen weiteren Sensorelements 50 sich unterscheiden.

Gemäß Figur 2 ist das (erste) Sensorelement 40 angrenzend zu einer Rückseite RS der Sensorvorrichtung 10 angeordnet, um in einem montierten Zustand eine Türgriffmulde an der Rückseite RS zu überwachen, wobei das weitere Sensorelement 50 - in Abschirmrichtung 202 gegenüberliegend - angrenzend zu einer Vorderseite FS der Sensorvorrichtung 10 angeordnet ist, um auf diese Weise in dem montierten Zustand einen vorderen Bereich des Türgriffs 2 an der Vorderseite FS zu überwachen. Ein Berühren (z. B. Auflegen der Hand) an dieser Vorderseite FS des Türgriffs 2 kann bspw. als weitere Aktivierungshandlung ein Verriegeln des Fahrzeuges 1 auslösen. Damit kann das weitere Sensorelement 50 einen Berührungssensor für den Türgriff 2 ausbilden. Hingegen kann durch das erste Sensorelement 40 bei Erfassung der Aktivierungshandlung als eine erste Aktivierungshandlung, insbesondere eine Annäherung und/oder ein Eingreifen in eine Türgriffmulde RS auf der Rückseite RS, eine erste Funktion des Fahrzeugs 1 initiiert werden, vorzugsweise ein Entriegeln und/oder Öffnen des Fahrzeuges 1. Damit kann das erste Sensorelement 40 als eine Sensorelektrode 40 zur Ausbildung eines Näherungssensors 40 am Türgriff 2 ausgeführt sein.

In Figur 3 ist eine Variante gezeigt, bei welcher eine Leiterplattenanpassung 80 der Leiterplattenanordnung 20 vorgesehen ist, um die Abschirmung zu unterstützten. Die Leiterplattenanpassung 80 kann dabei als eine Mehrzahl von Ausnehmungen, insbesondere Bohrungen, ausgeführt sein. Ferner ist im gezeigten Beispiel die Leiterplattenanpassung 80 der Leiterplattenanordnung 20 lagenübergreifend an einem Seitenbereich der Leiterplattenanordnung 20 vorgesehen, um in einem montierten Zustand einem Störelement 4, insbesondere einer Chromblende 4, des Türgriffs 2 zugewandt angeordnet zu sein, und um auf diese Weise einen Einfluss des Störelements 4 auf die Erfassung zu reduzieren. Konkret weist die gezeigte Leiterplattenanpassung 80 der Leiterplattenanordnung 20 mehrere Ausnehmungen der Leiterplatte der Leiterplattenanordnung 20 auf, welche versetzt und äquidistant in Abschirmrichtung 202 lagenübergreifend angeordnet sind.

Figur 5 zeigt neben einen Schnitt des Türgriffs 2 mit der Sensorvorrichtung 10 im montierten Zustand (bei I.) noch eine Darstellung (bei II.), in welcher gemäß einer Draufsicht auf den Türgriff 2 das Gehäuse 3 des Türgriffs 2 versetzt bzw. demontiert wurde. An einer Vorderseite FS des Türgriffs 2 ist eine Gehäuseanpassung 5 vorgesehen, welche bspw. eine Einkerbung und/oder ein anderes Material als das übrige Gehäuse 3 aufweisen kann. Auch kann die Gehäuseanpassung 5 als Kennzeichnung dienen, an welcher Stelle ein Bediener des Fahrzeuges 1 den Türgriff 2 berühren kann, um eine Funktion wie ein Verriegeln auszulösen. Hierzu ist im montierten Zustand hinter der Gehäuseanpassung 5 ein weiteres Sensorelement 50 an der Sensorvorrichtung 10 vorgesehen. Neben dem weiteren Sensorelement 50 kann noch ein zweites weiteres Sensorelement 50' vorgesehen sein, um z. B. eine Geste an der Vorderseite FS erfassen zu können. Ebenfalls erkennbar ist, dass eine in Figur 2 und 3 gezeigte Hochrichtung 203 im montierten Zustand am Fahrzeug 1 zumindest annähernd einer Fahrzeughochachse entsprechen kann, wobei je nach Montageposition auch Abweichungen dazu möglich sind. Eine Längsrichtung 201 kann z. B. annähernd einer Fahrzeuglängsrichtung entsprechen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 2: Türgriff
- 3: Gehäuse
- 4: Störelement, Chromblende
- 5: Gehäuseanpassung

- 10: Sensorvorrichtung

- 20: Leiterplattenanordnung, mehrlagige Leiterplatte
- 21: erste Lage
- 22: zweite Lage
- 23: dritte Lage
- 24: vierte Lage
- 25: Kontaktierung, Durchkontaktierung, Via

- 40: Sensorelement, erste Sensorelektrode für Näherungssensor

- 50: weiteres Sensorelement, zweite Sensorelektrode für Außenseitendetektion

- 60: Abschirmanordnung
- 61: erster Abschirmbereich, erstes Abschirmelement, erste Leiterbahn
- 62: zweiter Abschirmbereich, zweites Abschirmelement, zweite Leiterbahn
- 63: dritter Abschirmbereich, drittes Abschirmelement, dritte Leiterbahn

- 70: elektrische Anordnung
- 71: Verarbeitungsvorrichtung

- 80: Leiterplattenanpassung, Bohrungen
- 90: Leitungen
- 201: Längsrichtung
- 202: Querrichtung, Abschirmrichtung
- 203: Hochrichtung

- 50': weitere zweite Sensorelektrode
- Cf: Sensorkapazität
- Cp: Parasitäre Kapazität
- DA: Erfassungsbereich
- D1: erster Abstand
- D2: zweiter Abstand
- FS: Vorderseite, Außenseite
- RS: Rückseite, Türgriffmulde
- S: Gesamtsignal
- SA: Abschirmbereich
- Ocp: Offsetsignal
- Scf: Sensorsignal

## Patentansprüche

1. Sensorvorrichtung (10) zumindest zur kapazitiven Erfassung einer Aktivierungshandlung bei einem Fahrzeug (1), insbesondere für einen Türgriff (2) des Fahrzeuges (1), aufweisend:
- eine Leiterplattenanordnung (20) zur Bereitstellung einer elektrischen Anordnung (70) der Sensorvorrichtung (10), insbesondere für eine Türgriffelektronik,
- ein Sensorelement (40), welches elektrisch leitfähig an der Leiterplattenanordnung (20) ausgebildet ist, um die kapazitive Erfassung der Aktivierungshandlung bereitzustellen,
- eine Abschirmanordnung (60), welche elektrisch leitfähig an der Leiterplattenanordnung (20) in wenigstens zwei Abständen (D1, D2, D3) zum Sensorelement (40) ausgebildet ist, um eine Abschirmung in den Abständen (D1, D2, D3) für das Sensorelement (40) bereitzustellen, wobei die Abstände (D1, D2, D3) mit einem Einfluss auf die kapazitive Erfassung korrelieren,
wobei die Abstände (D1, D2, D3) insbesondere angepasst an die elektrische Anordnung (70) variieren, vorzugsweise maximiert sind, um den Einfluss begrenzt durch die elektrische Anordnung (70) zu reduzieren.

2. Sensorvorrichtung (10) nach Anspruch 1,
**dadurch gekennzeichnet,**
**dass** das Sensorelement (40) dazu ausgeführt ist, die kapazitive Erfassung in einem Erfassungsbereich (DA) bereitzustellen, um die Aktivierungshandlung als eine Annäherung im Erfassungsbereich (DA) zu detektieren, wobei die Abschirmanordnung (60) in einer Abschirmrichtung (202) versetzt mit den Abständen (D1, D2, D3) vom Sensorelement (40) angeordnet ist, und sich somit ungerade und vorzugsweise stufig gegenüber dem Sensorelement (40) erstreckt, um das Sensorelement (40) von einem Abschirmbereich (SA) in der Abschirmrichtung (202) gegenüberliegend zum Erfassungsbereich (DA) abzuschirmen.

3. Sensorvorrichtung (10) nach Anspruch 1 oder 2,
**dadurch gekennzeichnet,**
**dass** die Leiterplattenanordnung (20) als eine mehrlagige Leiterplatte (20) ausgebildet ist, sodass in Abschirmrichtung (202) verschiedene Lagen (21, 22, 23, 24) der Leiterplattenanordnung (20) vorgesehen sind, wobei die Abschirmanordnung (60) wenigstens zwei Abschirmelemente (61, 62, 63) aufweist, welche an unterschiedlichen der Lagen (21, 22, 23, 24) angeordnet sind, um hierdurch die Abstände (D1, D2, D3) in Abschirmrichtung zu variieren
und/oder dass das Sensorelement (40) und die Abschirmanordnung (60), insbesondere mit sämtlichen der Abschirmelemente (61, 62, 63) der Abschirmanordnung (60), zumindest teilweise in einer gemeinsamen Ebene angeordnet sind, welche orthogonal zur Leiterplattenebene einer Lage (21, 22, 23, 24) der Leiterplattenanordnung (20) ist, wobei vorzugsweise eine Abschirmrichtung (202) orthogonal zur Leiterplattenebene verläuft, und die Abstände (D1, D2, D3) in Richtung der Abschirmrichtung (202) variieren.

4. Sensorvorrichtung (10) nach einem der vorhergehenden Ansprüche,
**dadurch gekennzeichnet,**
**dass** der jeweilige Abstand (D1, D2, D3) als ein kürzester Abstand eines jeweiligen Abschirmelements (61, 62, 63) der Abschirmanordnung (60) vom Sensorelement (40) definiert ist, und über die Variation begrenzt durch die elektrische Anordnung (70) maximiert ist, um den Einfluss maximal zu reduzieren
und/oder dass eine Differenz von zwei der variierten Abstände (D1, D2, D3) einem ein- oder vielfachen Abstand zwischen zwei Lagen der Leiterplattenanordnung (20) entspricht, und insbesondere die variierten Abstände stets durch ein Ein- oder Vielfaches der Lagenabstände voneinander abweichen.

5. Sensorvorrichtung (10) nach einem der vorhergehenden Ansprüche,
**dadurch gekennzeichnet,**
**dass** der Einfluss auf die kapazitive Erfassung eine parasitäre Kapazität (Cp) ist, welche durch das Sensorelement (30) und die Abschirmanordnung (60) derart bereitgestellt ist und/oder wobei dadurch die Abstände (D1, D2, D3) mit dem Einfluss korrelieren, dass eine Verringerung des Abstands (D1, D2, D3) zwischen dem Sensorelement (40) und der Abschirmanordnung (60) die parasitäre Kapazität (Cp) erhöht, sodass der Einfluss für eine Beeinträchtigung bei der kapazitiven Erfassung spezifisch ist und/oder dass die Abschirmanordnung (60) abgestuft an der Leiterplattenanordnung (20) angeordnet ist, vorzugsweise über mehrere Lagen (21, 22, 23, 24) der Leiterplattenanordnung (20), sodass die Stufen (61, 62, 63) in den variierten Abständen (D1, D2, D3) zum Sensorelement (40) angeordnet sind.

6. Sensorvorrichtung (10) nach einem der vorhergehenden Ansprüche,
**dadurch gekennzeichnet,**
**dass** die Leiterplattenanordnung (20) als eine mehrlagige Leiterplatte (20) wenigstens zwei Lagen oder genau vier Lagen aufweist, und die Abschirmanordnung (60) wenigstens zwei Abschirmelemente (61, 62, 63) aufweist, welche auf unterschiedlichen der Lagen (21, 22, 23, 24) der Leiterplattenanordnung (20) befestigt sind, und durch wenigstens eine Kontaktierung (25), insbesondere Durchkontaktierung (25), miteinander elektrisch verbunden sind, wobei ein erstes (61) der Abschirmelemente einen ersten (D1) der Abstände zum Sensorelement (40) aufweist, und ein zweites (62) der Abschirmelemente einen zweiten (D2) der Abstände zum Sensorelement (40) aufweist.

7. Sensorvorrichtung (10) nach einem der vorhergehenden Ansprüche,
**dadurch gekennzeichnet,**
**dass** die Sensorvorrichtung (10) die elektrische Anordnung (70) aufweist, welche wenigstens eine Leitung der Sensorvorrichtung (10) und/oder wenigstens eine Verarbeitungsvorrichtung (71) und/oder wenigstens ein weiteres Sensorelement (50) aufweist, die jeweils über die Abschirmanordnung (60) vom Sensorelement (40) getrennt und/oder abgeschirmt sind und/oder die Abstände (D1, D2, D3) beeinflussen und/oder dass die Abschirmanordnung (60) wenigstens ein Abschirmelement (62) aufweist, welches dazu ausgeführt und insbesondere angeordnet ist, sowohl für das Sensorelement (40) als auch für ein weiteres Sensorelement (50) an der Leiterplattenanordnung (20) eine Abschirmung bereitzustellen.

8. Sensorvorrichtung (10) nach einem der vorhergehenden Ansprüche,
**dadurch gekennzeichnet,**
**dass** wenigstens ein Abschirmelement (62) der Abschirmanordnung (60) zwischen dem Sensorelement (40) und wenigstens einem weiteren Sensorelement (50) angeordnet ist, vorzugsweise in einer Lage (22) zwischen den Lagen (21, 24) dieser Sensorelemente (40, 50), um die Abschirmung als gegenseitige Abschirmung für mehrere Sensorelemente (40, 50) bereitzustellen.

9. Sensorvorrichtung (10) nach einem der vorhergehenden Ansprüche,
**dadurch gekennzeichnet,**
**dass** neben dem Sensorelement (40) als ein erstes Sensorelement (40) wenigstens ein weiteres Sensorelement (50) zur kapazitiven Erfassung an der Leiterplattenanordnung (20) angeordnet ist, wobei sich vorzugsweise ein erster Erfassungsbereich (DA) des ersten Sensorelements (40) von wenigstens einem weiteren Erfassungsbereich des wenigstens einen weiteren Sensorelements (50) unterscheidet, und wobei die Abschirmanordnung (60) zumindest teilweise benachbart zum wenigstens einen weiteren Sensorelement (50) angeordnet ist, um durch die Abschirmanordnung (60) und vorzugsweise wenigstens ein Abschirmelement (62) der Abschirmanordnung (60) sowohl für das erste Sensorelement (40) als auch für das weiteres Sensorelement (50) die Abschirmung von unterschiedlichen Abschirmbereichen bereitzustellen und/oder dass für das Sensorelement (40) und wenigstens ein weiteres Sensorelement (50) nur eine Abschirmanordnung (60) vorgesehen ist, welche ausschließlich elektrisch miteinander verbundene potentialgleiche Abschirmelemente (62, 63, 63) aufweist, wobei die Abschirmelemente (61, 62, 63) versetzt und/oder stufig über mehrere Lagen (21, 22, 23, 24) der Leiterplattenanordnung (20) zwischen den Sensorelementen (40) sich erstrecken.

10. Sensorvorrichtung (10) nach einem der vorhergehenden Ansprüche,
**dadurch gekennzeichnet,**
**dass** sämtliche Abschirmelemente (61, 62, 63) der Abschirmanordnung (60) auf einem gleichen Potential liegen und elektrisch miteinander, insbesondere lagenübergreifend, verbunden sind
und/oder dass die Abschirmanordnung (60) dazu ausgeführt ist, die Abschirmung als eine aktive Abschirmung bereitzustellen, um ein elektrisches Potential der Abschirmanordnung (60) dynamisch an die Erfassung durch das Sensorelement (40) anzupassen.

11. Sensorvorrichtung (10) nach einem der vorhergehenden Ansprüche,
**dadurch gekennzeichnet,**
**dass** das Sensorelement (40) als ein erstes Sensorelement (40) angrenzend zu einer Rückseite (RS) der Sensorvorrichtung (10) angeordnet ist, um in einem montierten Zustand eine Türgriffmulde (RS) an der Rückseite (RS) zu überwachen, wobei vorzugsweise ein weiteres Sensorelement (50), insbesondere in Abschirmrichtung (202) gegenüberliegend, angrenzend zu einer Vorderseite (FS) der Sensorvorrichtung (10) angeordnet ist, um in dem montierten Zustand einen vorderen Bereich des Türgriffs (2) an der Vorderseite (FS) zu überwachen
und/oder dass das Sensorelement (40) als ein erstes Sensorelement (40) dazu ausgeführt ist, bei Erfassung der Aktivierungshandlung als eine erste Aktivierungshandlung, insbesondere eine Annäherung und/oder ein Eingreifen in eine Türgriffmulde (RS), eine erste Funktion des Fahrzeugs (1) zu initiieren, vorzugsweise ein Entriegeln und/oder Öffnen des Fahrzeuges (1), und bevorzugt ein weiteres Sensorelement (50) dazu ausgeführt ist, bei Erfassung einer zweiten Aktivierungshandlung, insbesondere eine Berührung des Türgriffs (2) an einer Vorderseite (FS), eine zweite Funktion des Fahrzeugs (1) zu initiieren, vorzugsweise ein Verriegeln und/oder Schließen des Fahrzeuges (1).

12. Sensorvorrichtung (10) nach einem der vorhergehenden Ansprüche,
**dadurch gekennzeichnet,**
**dass** eine Leiterplattenanpassung (80) der Leiterplattenanordnung (20) vorgesehen ist, um die Abschirmung zu unterstützten, wobei die Leiterplattenanpassung (80) vorzugsweise als eine Mehrzahl von Ausnehmungen, insbesondere Bohrungen (80), ausgeführt ist.

13. Sensorvorrichtung (10) nach einem der vorhergehenden Ansprüche,
**dadurch gekennzeichnet,**
**dass** eine Leiterplattenanpassung (80) der Leiterplattenanordnung (20) lagenübergreifend an einem Seitenbereich der Leiterplattenanordnung (20) vorgesehen ist, um in einem montierten Zustand einem Störelement (4), insbesondere einer Chromblende (4), des Türgriffs (2) zugewandt angeordnet zu sein, um einen Einfluss des Störelements (4) auf die Erfassung zu reduzieren
und/oder dass eine Leiterplattenanpassung (80) der Leiterplattenanordnung (20) mehrere Ausnehmungen der Leiterplatte der Leiterplattenanordnung (20) aufweist, welche versetzt und insbesondere äquidistant in Längsrichtung (201) parallel zur Leiterplattenebene und orthogonal zur Abschirmrichtung (202) und/oder in Abschirmrichtung (202) lagenübergreifend angeordnet sind.

14. Türgriff (2) für ein Fahrzeug (1), mit einer Sensorvorrichtung (10) nach einem der vorhergehenden Ansprüche.

15. Verfahren zur Herstellung einer Sensorvorrichtung (10), insbesondere nach einem der vorhergehenden Ansprüche, wobei die nachfolgenden Schritte durchgeführt werden:
- Bereitstellen einer Leiterplattenanordnung (20), welche dazu ausgeführt ist, eine elektrische Anordnung (70) für die Sensorvorrichtung (10) zu tragen,
- Ausbilden eines Sensorelements (40) elektrisch leitfähig an der Leiterplattenanordnung (20),
- Ausbilden einer Abschirmanordnung (60) elektrisch leitfähig an der Leiterplattenanordnung (20) in wenigstens zwei Abständen (D1, D2, D3) zum Sensorelement (40), wobei die Abstände (D1, D2, D3) mit einem Einfluss auf die kapazitive Erfassung korrelieren,
wobei die Abstände (D1, D2, D3) insbesondere in Abhängigkeit von der elektrischen Anordnung (70) variiert werden, vorzugsweise maximiert werden, um den Einfluss begrenzt durch die elektrische Anordnung (70) zu reduzieren.
